Europäisches Patentamt

European Patent Office

Office européen des brevets

(11) Publication number: **0 161 776**
**B1**

(12) **EUROPEAN PATENT SPECIFICATION**

(45) Date of publication of patent specification: **18.01.89**

(51) Int. Cl.⁴: **G 01 N 27/74**

(21) Application number: **85302305.9**

(22) Date of filing: **02.04.85**

(54) **Detecting oxygen concentration in a gas.**

(30) Priority: **03.04.84 US 596482**

(43) Date of publication of application:
**21.11.85 Bulletin 85/47**

(45) Publication of the grant of the patent:
**18.01.89 Bulletin 89/03**

(84) Designated Contracting States:
**AT BE CH DE FR GB IT LI SE**

(56) References cited:
**GB-A-2 013 893**
**US-A-3 049 665**
**US-A-3 076 929**
**US-A-3 447 073**

**PATENTS ABSTRACTS OF JAPAN, vol. 6, no.
66 (P-112)944r, 27th April 1982; & JP - A - 57
8442 (HAJIME YAMADA) 16-01-1982**

(73) Proprietor: **THE BABCOCK & WILCOX
COMPANY
1010 Common Street P.O. Box 60035
New Orleans Louisiana 70160 (US)**

(72) Inventor: **Ciammaichella, Richard Curtis
13575 Ravenna Road
Chardon Ohio 44024 (US)**
Inventor: **Youmans, Barry J.
287 Nautilus Lane
Rittman Ohio 44270 (US)**

(74) Representative: **Cotter, Ivan John et al
D. YOUNG & CO. 10 Staple Inn
London WC1V 7RD (GB)**

EP 0 161 776 B1

**Description**

This invention relates to oxygen detectors for measuring oxygen concentration in a gas.

It is often important to measure the concentration of oxygen in various gases. For example, the use of an oxygen sensor for sensing the oxygen content in flue gases of combustion processes can be utilised to determine the efficiency of combustion.

Presently known detectors of oxygen ($O_2$) include the following:

wet chemical cells which suffer short life spans and require frequent recalibration;

zirconium oxide sensors which are fragile, poisoned by common flue gas constituents, require high operating temperatures and are difficult to manufacture;

paramagnetic analysers which use oxygen's paramagnetic properties to create a situation in which the $O_2$ concentration can be inferred from thermal conductivity measurements, or pressure measurements, where the inference is inaccurate due to effects of bulk gas composition, temperature and instrument attitude; and

magnetodynamic analysers which derive the susceptibility, by measuring force due to movement of a sample gas through a magnetic field, but are limited due to the low forces exerted and either linearity or vibration and shock resistance must be compromised.

Oxygen detectors for measuring oxygen concentration in gases are disclosed in US Patents Nos. US—A—3 049 665 and US—A—3 076 929, UK Patent Application No. GB—A—2 013 893 and Patent Abstracts of Japan, Vol. 6, Number 66 (P-112) (944), 27 April 1982 (and JP—A—57 8442).

The detector disclosed in the above-cited Abstract comprises a first electromagnet having a first core, a second electromagnet having a second core, a material (reference gas) of known magnetic permeability contained in a case which encloses the second electromagnet, respective current supply means for passing respective currents through the first and second electromagnets to generate magnetic fields therein, means for conducting the gas whose oxygen concentration is to be measured through a case containing the first electromagnet, and a magnetic flux sensor which differentially detects leakage fluxes of the first and second electromagnets to produce an output proportional to the oxygen concentration in the gas whose oxygen concentration is to be measured.

GB—A—2 013 893 (cited above) discloses the use of a Hall effect sensor positioned in an air gap of a magnetic circuit of the detector to measure magnetic flux in the air gap.

According to the present invention there is provided an oxygen detector for measuring oxygen concentration in a gas, the detector comprising:

a first electromagnet having a first core;

a second electromagnet which is substantially identical to the first electromagnet, the second electromagnet having a second core;

a material of known magnetic permeability disposed in the second core;

current supply means for passing current of a known value through the first electromagnet for generating a magnetic field having a known nominal magnetic flux density in the first core, the current supply means being connected to supply current to the second electromagnet to generate in the second core substantially the same nominal magnetic flux density as in the first electromagnet;

means for conducting the gas through the first core;

a first Hall effect sensor located within the first core at a position corresponding to substantially the maximum flux density of the first core;

a second Hall effect sensor located within the second core at a position corresponding to substantially the maximum flux density of the second core;

an auxiliary coil connected to the second electromagnet for receiving a variable current to balance the magnetic fields in the first and second cores in the absence of oxygen in the gas; and

means connected to the first and second Hall effect sensors for measuring any changes in the magnetic flux density between the first and second cores, which changes are proportional to oxygen concentration in the gas.

A preferred embodiment of the invention described hereinbelow measures the susceptibility of the gas directly, using a linear Hall effect sensor. Since the measurement is not dependent upon inference from the thermal conductivity or temperature effects, carrier gas composition presents less error. The only interferent which is known to be of potential significance is nitric oxide (NO), which has a relative susceptibility 43% that of oxygen at room temperature (see the Table appearing below). However, the relative volume of NO to $O_2$ in a typical flue gas mixture is less than 1/20, which reduces the calibration error to the range typically specified for zirconia based sensors. Careful control of the analyser at elevated temperatures can further reduce this error. For typical application of offset zero would eliminate error due to normal (usually constant) NO concentrations. Since the sensor is a solid-state, non-contact device, life expentancy, linearity, and shock resistance are superior to present online oxygen sensors.

The preferred embodiment of the invention uses the Hall effect to directly measure the paramagnetic influence of oxygen.

Paramagnetism is the property of certain substances wherein a magnetic field applied to the substances will increase by the alignment of electron orbits of the substances. The magnetic permeability of paramagnetic materials is slightly greater than that of empty space. Paramagnetic materials are

2

contrasted to diamagnetic materials in that diamagnetic materials slightly reduce a magnetic field applied to them and have a magnetic permeability which is slightly less than that of empty space.

The relatively high susceptibility (and thus paramagnetic property) of oxygen over that of most other gases and, specifically, most of the gases that would be found in flue gas, makes the paramagnetic property of oxygen useful as a measuring tool.

Relative magnetic susceptibilities on the scale nitrogen=0, oxygen=100

| | | | |
|---|---|---|---|
| Acetylene, $C_2H_2$ | −0.24 | Hydrogen $H_2$ | +0.24 |
| Allene, $C_3H_4$ | −0.44 | Hydrogen bromide, HBr | −0.61 |
| Ammonia, $NH_3$ | −0.26 | Hydrogen chloride, HCl | −0.30 |
| Argon, Ar | −0.22 | Hydrogen fluoride, HF | +0.10 |
| Bromine, $Br_2$ | −1.3 | Hydrogen iodide, HI | −1.1 |
| 1,2-Butadiene, $C_4H_6$ | −0.65 | Hydrogen sulphide, $H_2S$ | −0.39 |
| 1,3-Butadiene, $C_4H_6$ | −0.49 | Krypton, Kr | −0.51 |
| n-Butane, $C_4H_{10}$ | −1.3 | Methane, $CH_4$ | −0.2 |
| Isobutane, $C_4H_{10}$ | −1.3 | Neon, Ne | +0.13 |
| 1-Butene, $C_4H_8$ | −0.85 | Nitric oxide, NO | +43 |
| cis-2-Butene, $C_4H_8$ | −0.89 | Nitrogen, $N_2$ | 0.0 |
| Isobutene, $C_4H_8$ | −0.85 | Nitrogen dioxide, $NO_2$ | +28 |
| trans-2-Butene, $C_4H_8$ | −0.92 | Nitrous oxide, $N_2O$ | −0.2 |
| Carbon dioxide, $CO_2$ | −0.27 | n-Octane, $C_8H_{18}$ | −2.5 |
| Carbon monoxide, CO | +0.01 | Oxygen, $O_2$ | 100 |
| Chlorine, $Cl_2$ | −0.77 | n-Pentane, $C_5H_{12}$ | −1.45 |
| Ethane, $C_2H_6$ | −0.46 | Isopentane, $C_5H_{12}$ | −1.49 |
| Ethylene, $C_2H_4$ | −0.26 | Neopentane $C_5H_{12}$ | −1.49 |
| Helium, He | +0.30 | Propane, $C_3H_8$ | −0.86 |
| n-Heptane, $C_7H_{16}$ | −2.1 | Propylene, $C_3H_6$ | −0.545 |
| n-Hexane, $C_6H_{14}$ | −1.7 | Water, $H_2O$ | −0.02 |
| Cyclohexane, $C_6H_{12}$ | −1.557 | Xenon, Xe | −0.95 |

The Hall effect is a phenomenon wherein, when a conductor of ribbon shape is exposed to a magnetic field whose direction is transverse to a current in the ribbon, an electrostatic field appears whose direction is perpendicular to the magnetic field and the direction of the flow of charge due to the current. This effect is utilised in a Hall effect sensor which in turn can be used to measure a change in magnetic field due to the presence of oxygen in a gas to be tested, which gas is supplied to the core of an electromagnet or gap of a permanent magnet, whose nominal magnetic flux is known.

Hall effect output $(P_H)$ is proportional to magnetic flux density (B) and the flux generated by an electromagnet can be expressed in terms of permeability (μ), number (n) of turns in the coil, current (I) through the coil and the radius (r) of the coil by the equation:

$$(1) \qquad P_H = \frac{\mu n I}{2r}$$

The coil radius (r) and the number (n) of turns are obviously constants and the current (I) can be controlled as desired. Hence, the only variable which effects the flux (and, proportionately, the Hall output) is the permeability μ, which is dependent upon the material in the space of the field.

By passing a sample containing oxygen through the core of an electromagnet (or the gap of a permanent magnet), the gas composition can be computed from the changing flux knowing its permeability or susceptibility by the equation.

$$(2) \qquad X = \frac{\mu - 1}{\mu_o}$$

where

X=susceptibility,
μ=permeability of the gas, and
$\mu_o$=permeability of the volume.

The volume susceptibility of a mixture is proportional to the concentration of its constituents and inversely proportional to temperature. Oxygen has a volume susceptibility of $141.3 \times 10^{-9}$ as opposed to $60.3 \times 10^{-9}$ for nitric oxide, $-9.39 \times 10^{-9}$ for nitrogen, $-0.165 \times 10^{-9}$ for hydrogen, $-0.78 \times 10^{-9}$ for carbon dioxide, $-1.67 \times 10^{-9}$ for methane and $-1.88 \times 10^{-9}$ for propane. Hence, an electromagnet core will produce a higher flux density if filled with oxygen than with other flue gases. Nitric oxide is the only major interferant known, but will not cause a significant error in normal flue gas concentrations.

3

Note that the change in field from 100% $O_2$ to 100% $N_2$ will be very small in proportion to the absolute value of the applied field:

$$B_{\alpha\mu}$$

For $O_2 = (141.3 \times 10^{-9} + 1)$
For $N_2 = (-0.39 \times 10^{-9} + 1)$

(3) $$\frac{\mu O_2}{\mu N_2} = 1.0000014$$

However, if a very strong magnetic field is applied, the absolute change in B is very large:

(4) $B = \mu H$ so that if H (magnetic field) is very large, e.g. $H = 10^6$, $\Delta B = 1.4 = 0.000014\%$ B.

Then, to measure accurately with the Hall effect sensor, the span must equal $\Delta B$ and be offset to read zero at B nominal. This is accomplished by adding a second magnet whose field opposes the first ($\mu B$) and is not affected by $O_2$ concentration. This second magnet is used to cancel magnetic variation due to changing temperature power supply effect etc. by utilising an electromagnet similar to the first. Pulsing both also allows error cancelling of the magnetic permeance, as is done in magnetic flowmeters.

The invention will now be further described, by way of illustrative and non-limiting example, with reference to the accompanying drawings, in which:

Figure 1 is a perspective view, with portions cut away for clarity, of part of an oxygen detector embodying the invention;

Figure 2 is a perspective view of a Hall effect sensor;

Figure 3 shows the whole detector embodying the invention; and

Figure 4 is a block diagram of a circuit of the detector embodying the invention.

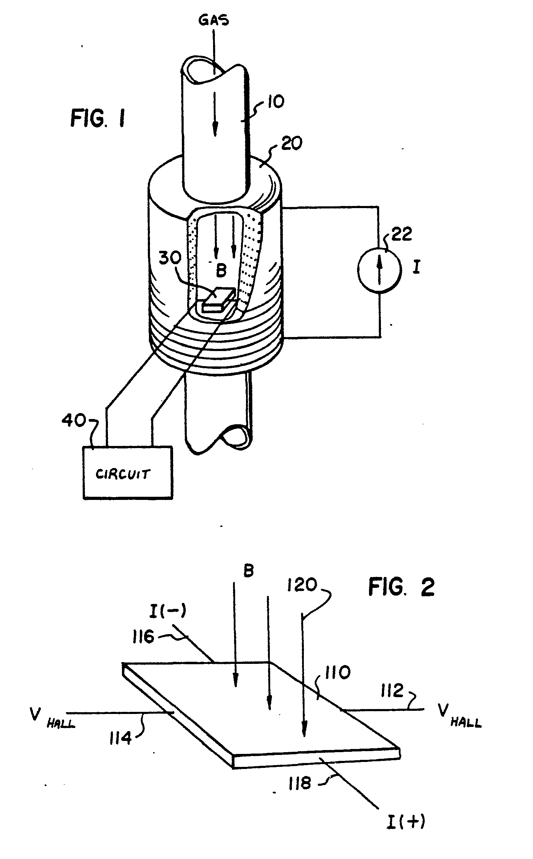

Figure 1 shows part of an oxygen detector for detecting oxygen concentrations in a gas supplied through a tube 10 to a core of an electromagnet 20. The electromagnet 20 comprises a coil having a large number of turns and supplied with a current by current supply means 22. The tube 10 is made of material having known permeability to the magnetic flux density B of a field generated by the electromagnet 20 and indicated by arrows. A Hall effect sensor 30 is provided in the coil of the electromagnet 20 for measuring the magnetic flux density B. The flux density B changes as the concentration of oxygen in the gas in the tube 10 changes and thus can be utilised, using a circuit 40, to provide a measurement of oxygen concentration. The sensor 30 is positioned at the best location for maximum fluid density.

Referring to Figure 2, a body 110 of the sensor is in the form of a flat rectangular strip of semiconductive material such as silicon. A current I is passed through the strip in a direction from a lead 118 to a lead 116. The magnetic field B, designated 120, is the physical variable to be sensed, and passes through the sensor in a direction perpendicular to its flat surface. The field interacts with the flowing current I to produce a voltage at right angles to both I and B, the voltage thus appearing between terminals 112 and 114. This voltage is proportional to the product of I and B.

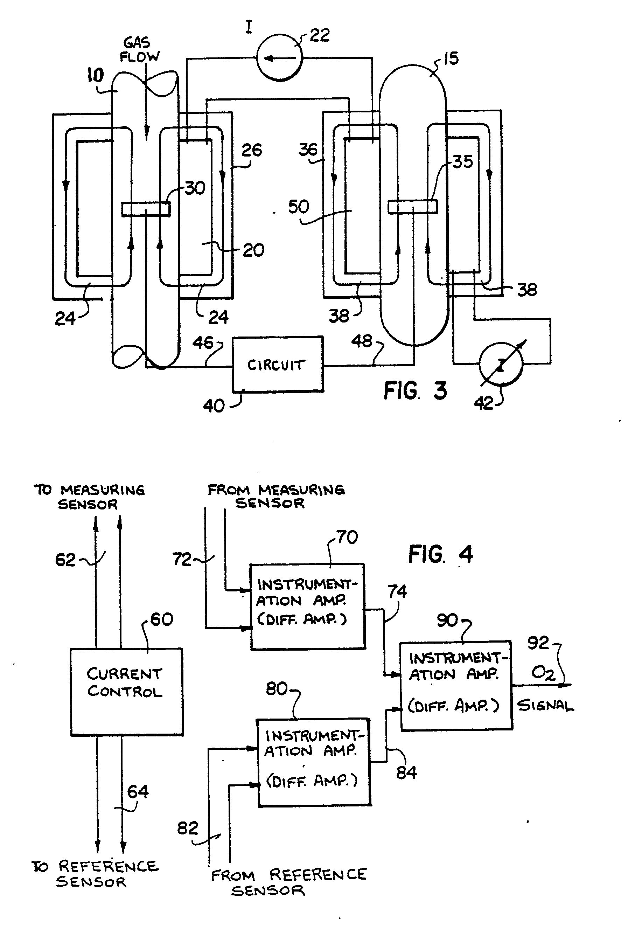

Figure 3 shows the whole of the oxygen detector which utilises two electromagnets 20 and 50. While the core of the electromagnet 20 is provided with the tube 10 for the measurement of oxygen concentration in a gas carried by the tube, the core of the electromagnet 50 is provided with a closed-ended (sealed) tube 15 containing a known gas sample. Any other material having known magnetic permeability may be provided in the core of the electromagnet 50. The electromagnets 20 and 50 are chosen to be as identical as possible so that all factors un-associated with the paramagnetism of oxygen are removed from the measurement procedure.

The electromagnets 20 and 50 are supplied, by the same current source 22, with the same current.

Hall-effect sensors 30 and 35 (measuring and reference sensors, respectively) are positioned in the fields of the electromagnets 20 and 50 which are of identical design as far as practical. An auxiliary coil is included in the electromagnet 50 to either buck or aid the field of the main coil. This is used to balance the electromagnet sensor pairs in the absence of $O_2$. A variable current 42 is used for effecting this adjustment.

Field shunts 24 and 38 are used to contain the external fields from the electromagnets 20 and 50, respectively. This confines the external paths to known conditions. The gas being measured flows through the tube 10. The reference unit contains the sealed tube 15 containing a known gas which is not $O_2$.

The circuit 40 is connected to both the sensors 30 and 35 to measure differences in the magnetic flux density of the two cores. When all of the factors are held constant, this measurement gives a signal representing the $O_2$ concentration in the measuring coil.

The circuit 40 is connected to each sensor by four wires, two each for current and two each for induced voltage measurements. Figure 4 shows a block diagram for this circuit.

Referring to Figure 4, the measuring and reference sensors are driven by currents generated by a current control circuit 60. The currents are maintained identical in amplitude and direction to each other by the circuit 60. Lines 62 deliver current to the measuring sensor 30 in Figure 3, and lines 64 deliver current to the reference sensor 35 in Figure 3.

Lines 72 connect the induced Hall effect voltage from the measuring sensor to a difference or instrumentation amplifier 70, which provides a voltage on a line 74 proportional to the true difference of voltage between the lines 72. Similarly, a line 84 gets a signal via an amplifier 80 proportional to the voltage difference between lines 82 receiving the Hall effect voltage induced in the reference sensor.

Since the $O_2$ signal is proportional to the difference of voltage between the lines 74 and 84, a similar true difference circuit or instrumentation amplifier to that used for the amplifiers 70 and 80 is used for an amplifier 90. The amplifier 90 extracts the $O_2$ related signal from the lines 74 and 84 and presents it on a line 92.

The instrumentation amplifiers 70, 80 and 90 may comprise Analog Devices AD 522 amplifiers, Burr Brown 3626 amplifiers, or the like. Improved accuracy can be obtained by using three matched and tracking amplifiers arranged on a single silicon chip or on a hybrid circuit substrate, along with the current sources.

The current used in the Hall effect sensors may be *dc* and the amplifiers similarly bandwidth limited and ultra-stable in *dc* operation. An alternative technique or mode is to employ a sinewave of current for the sensors, and amplifiers tuned to the frequency thereof. Such an *ac* or sinewave implementation will permit a much higher sensitivity of operation.

## Claims

1. An oxygen detector for measuring oxygen concentration in a gas, the detector comprising:
a first electromagnet (20) having a first core;
a second electromagnet (50) which is substantially identical to the first electromagnet (20), the second electromagnet (50) having a second core;
a material of known magnetic permeability disposed in the second core;
current supply means (22) for passing current of a known value through the first electromagnet (20) for generating a magnetic field having a known nominal magnetic flux density in the first core, the current supply means (22) being connected to supply current to the second electromagnet (50) to generate in the second core substantially the same nominal magnetic flux density as in the first electromagnet;
means (10) for conducting the gas through the first core;
a first Hall effect sensor (30) located within the first core at a position corresponding to substantially the maximum flux density of the first core;
a second Hall effect sensor (35) located within the second core at a position corresponding to substantially the maximum flux density of the second core;
an auxiliary coil connected to the second electromagnet (50) for receiving a variable current (42) to balance the magnetic fields in the first and second cores in the absence of oxygen in the gas; and
means (40) connected to the first and second Hall effect sensors (30, 35) for measuring any changes in the magnetic flux density between the first and second cores, which changes are proportional to oxygen concentration in the gas.

2. An oxygen detector according to claim 1, wherein the means (40) connected to the first and second Hall effect sensors (30, 35) is operative to measure the change in the magnetic flux density of the first core with respect to the nominal magnetic flux density of the second core.

3. An oxygen detector according to claim 1 or claim 2, wherein said Hall effect sensors (30, 35) provide signals corresponding to the induced Hall effect voltage in the Hall effect sensors.

4. An oxygen detector according to claim 3, wherein the means (40) connected to the first and second Hall effect means (30, 35) comprises a first differential amplifier (70) connected to the first Hall effect sensor (30) for receiving a first signal corresponding to the induced Hall effect voltage in the first Hall effect sensor, a second differential amplifier (80) connected to the second Hall effect sensor (35) for receiving a second signal corresponding to the induced Hall effect voltage in the second Hall effect sensor, and a third differential amplifier (90) connected to the first and second differential amplifiers (70, 80) for receiving said first and second signals and providing an output signal corresponding to the difference between said first and second signals, said output signal being proportional to the oxygen concentration in the gas.

5. An oxygen detector according to any one of the preceding claims, wherein the current supply means (22) for passing current through the first and second electromagnets (20, 50) is pulsed, thereby minimising the magnetic permeance of the first and second electromagnets.

## Patentansprüche

1. Sauerstoffmeßgerät zum Bestimmen der Sauerstoffkonzentration in einem Gas mit:
einem ersten Elektromagneten (20), welcher einen ersten Kern hat,
einem zweiten Elektromagneten (50), welcher im wesentlichen dem ersten Elektromagneten (20) gleich ist und welcher einen zweiten Kern hat,
einem Material bekannter magnetischer Permeabilität, welches in dem zweiten Kern angeordnet ist,
einer Stromzufuhreinrichtung (22), um einen Strom mit bekanntem Wert durch den ersten Elektromagneten (20) fließen zu lassen, um ein magnetisches Feld zu erzeugen, welches eine bekannte nominelle magnetische Flußdichte im ersten Kern hat, wobei die Stromzufuhreinrichtung (22) so angeschlossen ist, daß sie dem zweiten Elektromagneten (50) einen Strom zuführt, welcher in dem zweiten

5

Kern im wesentlichen dieselbe nominelle magnetische Flußdichte wie in dem ersten Elektromagneten erzeugt,

einer Einrichtung (10) zum Hindurchführen des Gases durch den ersten Kern,

einem ersten Halleffekt-Sensor (30), welcher in dem ersten Kern in einer Position angeordnet ist, die im wesentlichen der maximalen Flußdichte des ersten Kernes entspricht,

einem zweiten Halleffekt-Sensor (35), welcher in dem zweiten Kern in einer Position angeordnet ist, die im wesentlichen der maximalen Flußdichte des zweiten Kernes entspricht,

einer Hilfsspule, welche mit dem zweiten Elektromagneten (50) für die Aufnahme eines variablen Stromes (42) verbunden ist, um die magnetischen Felder in dem ersten und dem zweiten Kern bei Abwesenheit von Sauerstoff in dem Gas auszugleichen, und

einer Einrichtung (40), welche mit dem ersten und dem zweiten Halleffekt-Sensor (30, 35) verbunden ist, um jegliche Änderungen in der magnetischen Flußdichte zwischen dem ersten und dem zweiten Kern zu messen, wobei diese Änderungen proportional zur Sauerstoffkonzentration in dem Gas sind.

2. Sauerstoffmeßgerät nach Anspruch 1, dadurch gekennzeichnet, daß die Einrichtung (40), welche mit dem ersten und dem zweiten Halleffekt-Sensor (30, 35) verbunden ist, darauf ausgelegt ist, die Änderung in der magnetischen Flußdichte des ersten Kernes in Bezug auf die nominelle magnetische Flußdichte des zweiten Kernes zu messen.

3. Sauerstoffmeßgerät nach Anspruch 1 oder Anspruch 2, dadurch gekennzeichnet, daß die Halleffekt-Sensoren (30, 35) Signale erzeugen, welche der induzierten Halleffektspannung in den Halleffekt-Sensoren entsprechen.

4. Sauerstoffmeßgerät nach Anspruch 3, dadurch gekennzeichnet, daß die Einrichtung (40), welche mit der ersten und der zweiten Halleffekteinrichtung (30, 35) verbunden ist, einen ersten Differenzverstärker (70) aufweist, welcher mit dem ersten Halleffekt-Sensor (30) verbunden ist, um ein erstes Signal aufzunehmen, welches der induzierten Halleffektspannung in dem ersten Halleffekt-Sensor entspricht, weiterhin einen zweiten Differenzverstärker (80) aufweist, welcher mit dem zweiten Halleffekt-Sensor (35) verbunden ist, um ein zweites Signal aufzunehmen, welches der induzierten Halleffektspannung in dem zweiten Halleffekt-Sensor entspricht, sowie einen dritten Differenzverstärker (90), welcher mit dem ersten und dem zweiten Differenzverstärker (70, 80) verbunden ist, um das erste und das zweite Signal aufzunehmen und ein Ausgangssignal zu liefern, welches der Differenz zwischen dem ersten und dem zweiten Signal entspricht, wobei das Ausgangssignal proportional zur Sauerstoffkonzentration in dem Gas ist.

5. Sauerstoffmeßgerät nach einem der vorstehenden Ansprüche, dadurch gekennzeichnet, daß die Stromzufuhreinrichtung (22) für die Stromführung durch den ersten und den zweiten Elektromagneten (20, 50) impulsartig betrieben wird, wodurch der magnetische Leitwert des ersten und zweiten Elektromagneten minimiert wird.

**Revendications**

1. Détecteur d'oxygène en vue de la mesure de la concentration de l'oxygène dans un gaz, détecteur comportant:

un premier électro-aimant (20) possédant un premier noyau;

un second électro-aimant (50) qui est sensiblement identique au premier électro-aimant (20), le second électro-aimant (50) possédant un second noyau;

un matériau de perméabilité magnétique connue disposé dans le second noyau;

des moyens d'alimentation en courant (22) en vue de faire passer un courant d'intensité connue à travers le premier électro-aimant (20) en vue d'engendrer un champ magnétique possédant une densité de flux magnétique nominale connue dans le premier noyau, les moyens d'alimentation en courant (22) étant raccordés pour délivrer un courant au second électro-aimant (50) en vue d'engendrer dans le second noyau sensiblement la même densité de flux magnétique nominale que dans le premier électro-aimant;

des moyens (10) en vue d-acheminer le gaz à travers le premier noyau;

un premier capteur à effet Hall (30) disposé à l'intérieur du premier noyau en une position correspondant à sensiblement la densité de flux maximale du premier noyau;

un second capteur à effet Hall (35) disposé à l'intérieur du second noyau en une position correspondant à sensiblement la densité de flux maximale du second noyau;

une bobine auxiliaire connectée au second électro-aimant (50) en vue de recevoir un courant variable (42) pour équilibrer les champs magnétiques dans les premier et second noyaux en l'absence l'oxygène dans le gaz; et

des moyens (40) reliés aux premier et second capteurs à effet Hall (30, 35) en vue de mesurer des variations de densité de flux magnétique entre les premier et second noyaux, variations qui sont proportionnelles à la concentration de l'oxygène dans le gaz.

2. Détecteur d'oxygène selon la revendication 1, dans lequel les moyens (40) reliés aux premier et second capteurs à effet Hall (30, 35) agissent pour mesurer la variation de densité de flux magnétique du premier noyau par rapport à la densité de flux magnétique nominale du second noyau.

3. Détecteur d'oxygène selon la revendication 1 ou la revendication 2, dans lequel lesdits capteurs à effet Hall (30, 35) délivrent des signaux correspondant à la tension de Hall induite dans les capteurs à effet Hall.

4. Détecteur d'oxygène selon la revendication 3, dans lequel les moyens (40) reliés aux premier et second moyens à effet Hall (30, 35) comportent un premier amplificateur différentiel (70) relié au premier capteur à effet Hall (30) en vue de recevoir un premier signal correspondant à la tension de Hall induite dans le premier capteur à effet Hall, un second amplificateur différentiel (80) relié au second capteur à effet Hall (35) en vue de recevoir un second signal correspondant à la tension de Hall induite dans le second capteur à effet Hall, et un troisième amplificateur différentiel (90) relié aux premier et second amplificateurs différentiels (70, 80) en vue de recevoir lesdits premier et second signaux et de délivrer un signal de sortie correspondant à la différence entre lesdits premier et second signaux, ledit signal de sortie étant proportionnel à la concentration de l'oxygène dans le gaz.

5. Détecteur d'oxygène selon une quelconque des revendications précédentes, dans lequel les moyens d'alimentation en courant (22) en vue de faire passer un courant à travers les premier et second électro-aimants (20, 50) est pulsé, minimisant ainsi la perméance magnétique des premier et second électro-aimants.

FIG. 1

GAS

10

20

30

B

22

I

40

CIRCUIT

B

120

FIG. 2

I(−)

116

110

112

$V_{HALL}$

$V_{HALL}$

114

118

I(+)

FIG. 3

FIG. 4